Europäisches Patentamt

European Patent Office

Office européen des brevets

(11) Veröffentlichungsnummer: **0 618 453 A2**

# (12) EUROPÄISCHE PATENTANMELDUNG

(21) Anmeldenummer: **94102260.0**

(22) Anmeldetag: **15.02.94**

(51) Int. Cl.5: **G01R 31/28**

(30) Priorität: **26.03.93 DE 4309842**

(43) Veröffentlichungstag der Anmeldung:
**05.10.94 Patentblatt 94/40**

(84) Benannte Vertragsstaaten:
**DE FR GB IT**

(71) Anmelder: **ARNOLD EDV GmbH**
**Gehlmühle 1-3**
**D-76887 Birkenhördt (DE)**

(72) Erfinder: **Arnold, Harald**
**Gehlmühle 3**
**D-76887 Birkenhördt (DE)**

(54) **Verfahren zum Testen von Platinen und Vorrichtungen zur Durchführung des Verfahrens.**

(57) Zum Testen von Platinen, die mit integrierten Halbleiterschaltkreisen und sonstigen Bauelementen bestückt sind, auf Pinkontakt und Integrität der Funktionsgruppen wird zwischen je einem Paar von Teststiften (S0-S1, S0-S2...), gegebenenfalls auch eine Knickspannung (UK) gemessen. Diese Istwerte werden mit in einem Speicher abgelegten Vergleichswerten verglichen und ausgewertet. Die Vergleichswerte werden in einer speziellen Testphase einmalig unter Verwendung einer intakten Platine ermittelt, wobei wiederum zwischen Paaren von Teststiften (S0-S1, S0-S2...) die komplexen Impedanzen (ZV = DU/DI) gemessen und als Gut-Werte gespeichert werden. Um den Einfluß von fehlenden Pinkontakten auf die komplexen Impedanzen simbolisieren zu können, ist ein spezieller Testadapter (TA) vorgesehen, der zwischen Platine (1) und zu testendem Bauelement (IC) geschaltet wird und der in seinem Inneren eine Vielzahl von Testadapterleitungen mit Unterbrecherkontakten (U0, U1, U2...) besitzt, die mit Hilfe von Relais (RL0, RL1...) nacheinander geöffnet werden können.

Fig. 4

Die Erfindung betrifft ein Verfahren zum Testen von Platinen, die mit integrierten Halbleiterschaltkreisen und sonstigen Bauelementen bestückt sind, gemäß dem Oberbegriff des Anspruches 1 sowie eine Vorrichtung zur Durchführung des Verfahrens.

Die Qualitätskontrolle bei der Herstellung von bestückten Schaltungsplatinen setzt voraus, daß jede Schaltungsplatine vor der Auslieferung an den Kunden getestet wird, um festzustellen, ob Kurzschlüsse oder Unterbrechungen vorhanden sind, ob die richtigen Bauelemente an den richtigen Stellen richtig montiert und ob die Elemente, insbesondere die integrierten Schaltkreise, intakt sind. Selbst bei erfolgter Eingangskontrolle aller Bauteile sind die bei der Produktion möglichen Fehler abzuprüfen.

Ursprünglich wurden alle Platinen einem Vollfunktionstest unterzogen. Mit zunehmender Komplexität der Bestückung wurde der Vollfunktionstest immer unwirtschaftlicher. Es wurden dann spezielle Testprogramme entwickelt, die eine eindeutige Aussage erlaubten, ob die Platine in Ordnung ist oder nicht. Mit weiter zunehmender Komplexität der Schaltungen wurde die Entwicklung dieser Testprogramme immer zeitaufwendiger und kostspieliger, so daß auch diese Testverfahren unwirtschaftlich wurden.

Es wurden Testverfahren entwickelt, die es erlaubten, Bausteine, beispielsweise hochkomplexe integrierte Schaltkreise, auch im eingebauten Zustand testen zu können. Die erste Variante zeigt die DE 25 34 502 A1. Es handelt sich hierbei um einen integrierten Schaltkreis mit einem zusätzlich steuerbaren elektronischen Schalter, dem über eine gesonderte Anschlußfahne ein Schaltsignal zugeführt werden kann, was eine Anschaltung dieses Bausteins an die Testschaltung bewirkt, während alle anderen Bausteine abgeschaltet bleiben. Hier werden also spezielle integrierte Schaltkreise mit fest implementierten Testschaltern benötigt; dieses Testverfahren konnte sich daher in der Praxis nicht durchsetzen.

Ein anderes Testverfahren ist beschrieben in der EP-N 0 292 137 A2. Bei diesem Testverfahren läßt man einen ersten Strom i1 von einem Eingangspin des integrierten Schaltkreis zum Substrat (GND) fließen. Anschließend läßt man einen zweiten Strom i2 von einem anderen Pin, vorzugsweise dem Ausgangspin, zum Substrat (GND) fließen. Dabei ergibt sich eine charakteristische Abhängigkeit des Stroms i2 von der Größe des Stroms i1, wenn der integrierte Schaltkreis intakt ist und seine Anschlußpins richtig angelötet sind. Leider ist dieses Verfahren sehr stromintensiv, sehr temperaturabhängig, stark abhängig von der Außenbeschaltung des integrierten Schaltkreises und bedarf eines ausgefeilten Testprogramms, um den Gut-Schlecht-Vergleich sicher durchführen zu können. Auch werden immer nur die Teile des integrierten Schaltkreises getestet, die gegen das Substrat (GND) geschaltet sind; die Teile, die zwischen Eingangs- bzw. Ausgangspin und Versorgungsspannung (VCC) geschaltet sind, können nicht, jedenfalls nicht direkt gemessen werden.

Ein weiteres Testverfahren ist bekannt aus DE 41 10 551C1. Dieses Verfahren basiert auf der Existenz parasitärer Transistoren, die aufgrund der Integrationstechniken im Halbleiterschaltkreis entstehen. Das Testverfahren wertet die parasitären Transistoren aus, in dem an die Basis-Kollektor-Diode eine Spannung angelegt und in die Basis-Emiter-Diode ein Strom eingespeist wird. Im Gegensatz zu dem zuvor beschriebenen Testverfahren erlaubt dieses Testverfahren nicht nur die gegen das Substrat geschalteten Teile des integrierten Halbleiterschaltkreises auszumessen, sondern auch die gegen die Versorgungsspannung VCC geschalteten Teile, falls aufgrund der speziellen Integrationstechnik auch dort parasitäre Transistoren vorhanden sein sollten.

Allerdings erfassen die beschriebenen Testverfahren vom Prinzip her keine Fehler, die in einem zwischen dem Eingangspin und Ausgangspin liegenden Teil des Halbleiterschaltkreises versteckt sind. Auch sind Messungen über mehrere integrierte Halbleiterschaltkreise hinweg nicht möglich. Ebensowenig ist es vom Prinzip her möglich, Fehler in der Außenbeschaltung der integrierten Halbleiterschaltkreise zu erfassen. Schließlich benötigen die bekannten Testverfahren zwei Paare von Teststiften, um die beiden Testströme bzw. den Teststrom und die Testspannung einspeisen zu können.

Aus der DE 35 43 699 A1 ist ein In-Circuit-Test zum Prüfen der einzelnen Bauelemente einer Leiterplatte bekannt, bei dem während eines Funktionstestablaufs und/oder während des Ablaufs eines Simulationsprogramms das Verhalten der einzelnen zu prüfenden Bauelemente erfaßt und als Bauelementeinformation in eine Bauelementebibliothek eingegeben wird. Daraus und aus der Schaltungsbeschreibung wird dann ein Prüfprogramm erzeugt, in das das Zeitdiagramm der Ein- und Ausgänge aller auf der leiterplatte vorhandenen Bauelemente als Informationswert eingeht.

Der vorliegenden Erfindung liegt die Aufgabe zugrunde, ein Testverfahren der eingangs genannten Art und eine zum Durchführen des Verfahrens anzugeben, die nicht nur einen integrierten Halbleiterschaltkreis auf einer Platine, sondern beliebig komplex bestückte Platinen testen können, wobei ein sicherer Gut-Schlecht-Vergleich mit einem vollautomatischen, computergesteuerten Testequipment möglich ist und auf einen teuren In-Circuit-Adapter zugunsten einer Flying-Probe verzichtet werden kann.

Diese Aufgabe wird gelöst durch ein gattungsgemäßes Verfahren mit den im Anspruch 1 angegebenen Verfahrensschritten sowie eine Vorrichtung mit den im Anspruch 7 angegebenen Merkmalen.

Beim erfindungsgemäßen Verfahren unterscheidet man also zwischen einer Lernphase, während der unter Verwendung einer intakten Platine die Gut- Schlecht-Vergleichswerte aufgenommen und in einem Speicher abgelegt werden, und der eigentlichen Testphase, in der die entsprechenden Istwerte der zu prüfenden Platine gemessen und mit den Vergleichswerten verglichen werden, worauf dann der Gut-Schlecht-Vergleich durchgeführt wird. Dabei ist nur ein Paar Teststifte nötig; es wird also auch ohne teures Testbett nur mit einer Flying-Probe eine hohe Prüftiefe erreicht. Da jedes Bauelement eine charakteristische Impedanz besitzt, können mit dem erfindungsgemäßen Testverfahren beliebig komplexe Funktionsteile von integrierten Halbleiterschaltkreisen, Serien- oder Parallelschaltungen von integrierten Halbleiterschaltkreisen untereinander und mit anderen Bauelementen sowie herkömmliche aktive und/oder passive Bauelemente getestet werden. Es ist also ohne weiteres möglich festzustellen, ob Kondensatoren, Induktivitäten oder Widerstände die richtigen Werte besitzen usw. Ein ganz wesentlicher Vorteil ist dabei, daß das Prüfprogramm in der Lernphase vollautomatisch erstellt wird und in der Testphase mit großer Geschwindigkeit abläuft.

Es versteht sich, daß bei einem derartigen systematischen Testverfahren nicht jede Teststiftpaarung Gut- und Schlecht-Werte liefert, die sich signifikant unterscheiden. Gemäß einer bevorzugten Weiterbildung der Erfindung werden nur die Paarungen von Teststiften ausgemessen, deren Vergleichswerte signifikante Unterschiede besitzen. Dadurch läßt sich die Menge der Daten begrenzen, ohne daß die Testgenauigkeit leidet.

Vorteilhafterweise werden nicht nur die charakteristischen Impedanzen gemessen, sondern auch die Vergleichwerte bzw. die Istwerte der Knickspannung bestimmt, indem die Testspannung an dem aktiven Paar von Teststiften so lange erhöht wird, bis ein sprunghaft steigender Knickstrom gemessen werden kann. Diese Erweiterung des Testverfahrens eignet sich insbesondere für integrierte Halbleiterschaltungen, in denen bauteilspezifische Halbleiterübergänge und Leckströme vorhanden sind.

Durch die Messung des differentiellen Widerstandes im Durchlaßbereich der Ein- und Ausgangsimpedanzen kann ein absoluter Widerstandswert der Lötstellen errechnet werden und deren Qualität damit nachgewiesen werden.

Tatsache ist, daß insbesondere diese Knickspannungen bei von unterschiedlichen Herstellern produzierten integrierten Halbleiterschaltkreisen desselben Typs unterschiedlich sind, was durch den jeweiligen Integrationsprozeß bedingt ist. Werden nun während der Testphase integrierte Halbleiterschaltkreise unterschiedlicher Hersteller gemessen, erhält man unterschiedliche Istwerte. Unter Anwendung der Kirchhoff'schen Gleichungen ist nachweisbar, daß es möglich ist, die Vergleichswerte der integrierten Halbleiterschaltkreise der verschiedenen Hersteller in einer Datenbank abzulegen und vollautomatisch zu berücksichtigen, so daß das erfindungsgemäße Testverfahren auch bei derart wechselnden Bestückungen fehlerfrei funktioniert.

Wie schon erwähnt, ist es mit dem erfindungsgemäßen Testverfahren möglich, beliebige Teile von Schaltungsplatinen und Teile im Inneren eines integrierten Halbleiterschaltkreises zu erfassen. In manchen Fällen kann nun die Notwendigkeit bestehen, bestimmte Funktionsteile auf einer Platine oder in einem integrierten Halbleiterschaltkreis für die Testmessungen abzuschalten. In diesem Fall wird gemäß einer Weiterbildung der Erfindung eine Guard-Spannung bzw. ein Guard-Strom an die bzw. in die integrierte Halbleiterschaltung angelegt bzw. eingespeist. Die Höhe der Guard-Spannung entspricht immer der momentanen Höhe der Testspannung, während der Guard-Strom sich entsprechend der Impedanz des abzuschaltenden Funktionsteils automatisch so einstellt, daß der resultierende Strom zu Null wird.

Das erfindungsgemäße Testverfahren läßt sich noch dadurch erweitern, daß zusätzliche Vergleichswerte bzw. Istwerte von Spannung, Strom bzw. Impedanz an einem weiteren Paar von Teststiften bestimmt werden. An diesem weiteren Paar von Teststiften erfolgt lediglich eine Messung; Ströme oder Spannungen werden nicht eingespeist. Dadurch können durch wechselnde Beschaltung der ic's resultierende Fehlerströme erkannt und kompensiert werden.

Schließlich besteht in sehr vielen Fällen die Möglichkeit, die Messung der komplexen Impedanz zu ersetzen durch eine Messung des differentiellen Widerstands anhand zweier Spannungs- und Strommessungen, wodurch sich der Umfang der Datenbank reduzieren läßt.

Eine Testvorrichtung zur Durchführung des erfindungsgemäßen Verfahrens besteht aus einem an sich bekannten Testbett (In-Circuit-Adapter oder Flying-Probe) mit Teststiften, die den elektrischen Kontakt zu der zu prüfenden Plastine herstellen, einem Testspannungsgenerator, einem Testspannungsmeßgerät, welches zur Erhöhung der Meßgenauigkeit vorzugsweise in einer Pseudo-Vierdraht-Schaltung an die Platine angekoppelt wird, einem Teststrommeßgerät und einer Vorrichtung zur Errechnen der Impedanz. In der Praxis wird außerdem ein Testcomputer vorgesehen sein, der den gesamten Verfahrensablauf in der Lernphase bzw. in der Testphase steuert.

Des weiteren kann die erfindungsgemäße Testvorrichtung einen Guard-Verstärker umfassen, der, wie schon erwähnt, eine Guard-Spannung erzeugt, deren Höhe immer gleich der momentanen Höhe der Testspannung ist und einen Guard-Strom abgibt, der den störenden Teil des Teststroms genau kompensiert.

Eine Besonderheit der erfindungsgemäßen Vorrichtung ist ein Testadapter, der in der Lernphase zwischen Platine und jedem zu prüfenden Bauelement, vorzugsweise jedem integrierten Halbleiterschaltkreis, eingesetzt wird. Dieser Testadapter enthält in jeder Adapterleitung einen Unterbrecherkontakt, vorzugsweise betätigt durch ein Relais, so daß es möglich ist, wie gewünscht nacheinander jeden Anschlußpin des integrierten Schaltkreises oder sonstigen Bauelements systematisch aufzutrennen, um so die Auswirkungen von schlechten Lötstellen oder defekten Funktionsgruppen simulieren zu können.

Anhand der Zeichnung soll die Erfindung in Form von Ausführungsbeispielen und Diagrammen näher erläutert werden. Es zeigen

Fig. 1　ein allgemeines Ersatzschaltbild eines integrierten Schaltkreises zwecks Erläuterung des erfindungsgemäßen Verfahrens,

Fig. 2　die dazu gehörende prinzipielle Kennlinie,

Fig. 3　das Blockschaltbild einer einfachen Schaltung mit zwei integrierten Halbleiterschaltkreisen,

Fig. 4　einen typischen Testaufbau während der Lernphase und

Fig. 5　eine Testvorrichtung als Blockschaltbild.

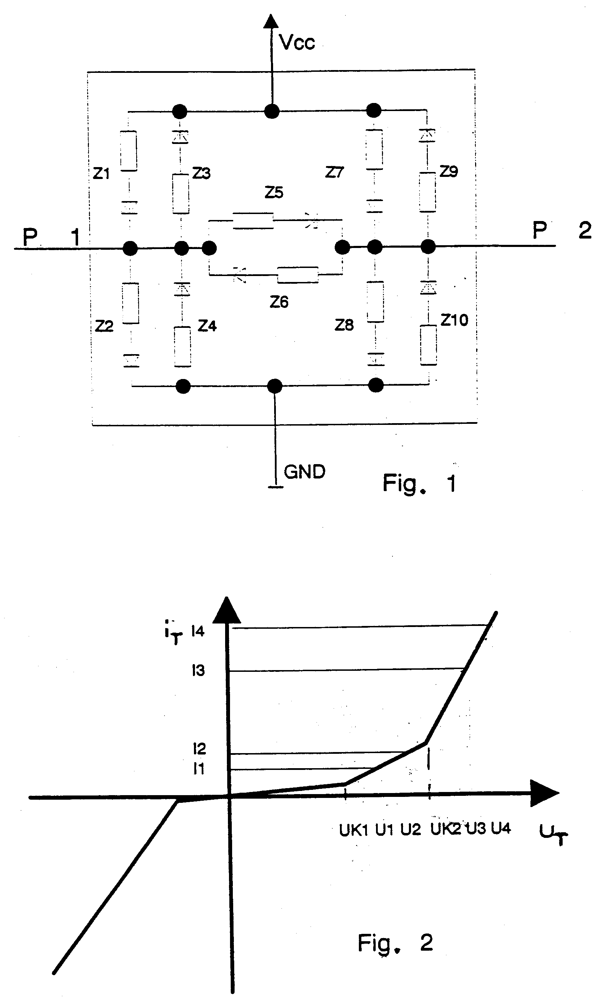

Fig. 1 zeigt ein Ersatzschaltbild eines Halbleiterschaltkreises, wie es für die Testmessungen relevant ist. Zwischen der Versorgungsspannung VCC und Ground GND erkennt man einen Eingangspin P1 sowie einen Ausgangspin P2 und dazwischen jeweils Funktionsgruppen aus Dioden, Widerständen und/oder Zenerdioden, die ihrerseits in Serie, parallel oder antiparallel geschaltet sind. Diese Funktionsgruppen sind mit Z1, Z2... Z10 bezeichnet. Es versteht sich, daß es sich hier um ein allgemeingültiges Ersatzschaltbild handelt; in einem konkreten integrierten Halbleiterschaltkreis sind in der Regel nicht alle Funktionsgruppen realisiert.

Die vorhandenen Funktionsgruppen werden ausgemessen, indem die komplexe Impedanz und gegebenenfalls die typischen Knickspannungen gemessen werden. Dabei lassen sich auch die Funktionsgruppen Z5, Z6 zwischen Eingangs- und Ausgangspin P1, P2 erfassen. Dies ist mit den bekannten Testverfahren nicht möglich.

Die Fig. 2 zeigt eine prinzipielle Spannung-Strom-Kennlinie, wie sie zwischen zwei Teststiften gemessen wird. Solange die komplexen Impedanzen nichtleitend sind, fließt bei steigender Testspannung $u_T$ nur ein verschwindend kleiner Teststrom $i_T$. Erst wenn die knickspannung $u_{K1}$ überschritten wird, steigt der Teststrom $i_T$ sprunghaft an. Ein weiterer sprunghafter Stromanstieg tritt ein, wenn die zweite Knickspannung $u_{K2}$ überschritten wird.

Anschließend wird der komplexe Widerstand ausgemessen, wobei in vielen Fällen eine Ausmessung des differentiellen Widerstandes durch zwei Spannungs- und Strommessungen ($u_1$, $u_2$; $i_1$, $i_2$) genügt. Hat die Kennlinie mehrere Knicke, können weitere Spannungs- und Strommessungen ($u_3$, $u_4$; $i_3$, $i_4$) vorgenommen werden. Die aktuellen Werte von Impedanz bzw. Widerstand sind abhängig von der Innenbeschaltung und der Außenbeschaltung des integrierten Halbleiterschaltkreises. Gleiches gilt auch für die Knickspannungen, wobei hier jedoch zusätzlich eine Abhängigkeit von der Herkunft des Schaltkreises aufgrund des jeweiligen Integrationsverfahrens erkennbar ist.

In gleicher Weise läßt sich auch der negative Teil der Kennlinie bei umgekehrter Polarität von Testspannung $u_T$ und Teststrom $i_T$ auswerten.

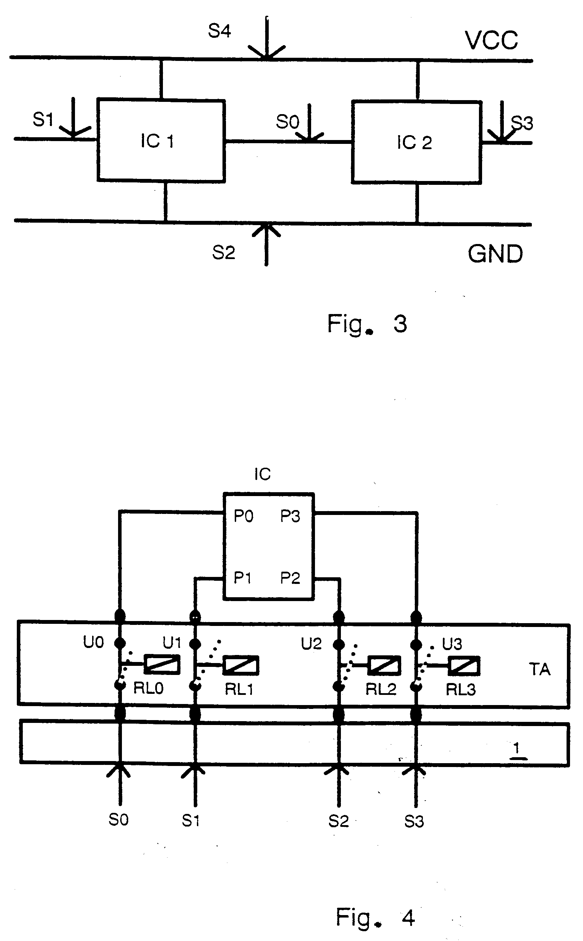

Fig. 3 zeigt ein einfaches Blockschaltbild einer Platine mit nur zwei integrierten Halbleiterschaltkreisen IC1, IC2. Teststifte S0, S1, S2, S3, S4 sind an allen zu testenden Punkten der Platine angesetzt. Die Messung selbst erfolgt immer zwischen einem Paar von Teststiften S0-S1, S0-S2... Werden alle Paarungen in beiden Polaritäten ausgemessen, erhält man insgesamt n x (n - 1) Meßreihen, die in der Lernphase in einem Speicher abgelegt und in der Testphase als Vergleichswerte mit den Istwerten verglichen werden. In der Praxis reduzierten sich diese Zahlen, da, wie schon erwähnt, nicht alle Funktionsgruppen vorhanden sind und da nicht alle Meßpaarungen signifikante Unterschiede zwischen Gut und Schlecht ergeben.

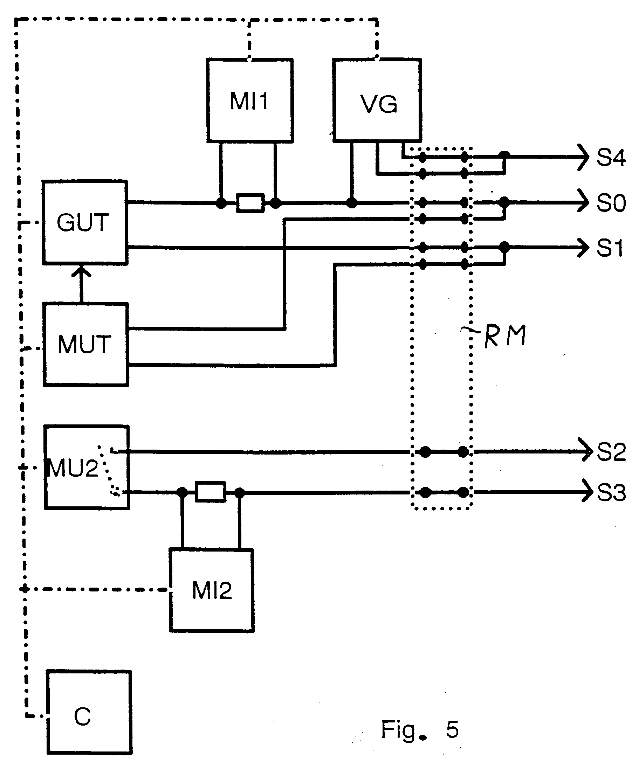

Fig. 4 zeigt den Testaufbau in der Lernphase, mit dessen Hilfe nicht nur die Gut-Werte, sondern auch alle Schlecht-Werte systematisch gemessen und gespeichert werden. Man erkennt die Teststifte S0, S1, S2, S3 eines (nicht dargestellten) Testbetts, die eine intakte Schaltungsplatine 1 kontaktieren. Zwischen Platine 1 und integriertem Halbleiterschaltkreis IC ist zusätzlich ein Testadapter TA eingesetzt, in dessen Innerem man eine Vielzahl von Adapterleitungen erkennt, von denen jede einen Unterbrecherkontakt $U_0$, $U_1$, $U_2$... aufweist, betätigt von Relais RL0, RL1, RL2...

Erfolgt nun während der Lernphase eine Messung zwischen den Teststiften S0 und S1 sind

zunächst alle Unterbrecherkontakte $U_o...U_x$ geschlossen. Anschließend werden der Reihe nach alte Unterbrecherkontakte $U_o...U_x$ nacheinander geöffnet, wobei jeweils der zwischen den aktiven Teststiften S0-S1 gemessene Wert von Impedanz $Z_v$ bzw. Widerstand $R_v$ und Knickspannung $U_K$ als Vergleichswert abgespeichert wird. Dadurch kann der Einfluß eines fehlenden Pins gemessen und in einer Datenbank abgelegt werden. Durch die Bestimmung des differentiellen Widerstandes $Z_r$, der bauteilspezifisch ist, in Abhängigkeit von der Spannung kann auch bei Bus-Strukturen durch Anwendung der Kirchhoff'schen Gleichungen der fehlerhafte Bausteinpin genau bestimmt werden.

Dieser Vorgang wird reihum für alle Paarungen von Teststiften S0, S1, S2... durchgeführt, bis alle Gut- und Schlecht-Werte abgespeichert sind.

Während der Testphase fehlt natürlich der Testadapter TA. Werden nun die Istwerte von Impedanz $Z_{ist}$, Widerstand $R_{ist}$ und Knickspannung $U_{Kist}$ aufgenommen, kann durch einen Vergleich mit den abgespeicherten Werten sehr einfach und vor allem sicher und schnell festgestellt werden, ob ein Gut- oder ein Schlecht-Wert vorliegt.

Es versteht sich, daß sich nach diesem Verfahren nicht nur ein einzelner Halbleiterschaltkreis ausmessen läßt, sondern beliebige Kombinationen von Halbleiterschaltkreisen und sonstigen Bauelementen auf der Platine 1. Bei passiven Bauelementen wird natürlich keine Knickspannung ermittelt; vielmehr werden die Real- und Imaginärteile der komplexen Impedanzen ausgewertet.

Fig. 5 schließlich zeigt den prinzipiellen Aufbau eines Testequipments. Man erkennt die Platine 1 und die auf sie aufgesetzten Teststifte S0, S1... S4, einen Testspannungsgenerator $GU_T$, ein zugehöriges Testspannungsmeßgerät $MU_T$ und Teststrommeßgerät $MI_T$, die mit Hilfe einer Relaismatrix RM zur Ausmessung der komplexen Impedanzen an die Teststifte S0... S4 geschaltet sind. Dabei erfolgt die Anschaltung des Testspannungsmeßgerätes $MU_T$ mit Hilfe einer Pseudo-Vierdraht-Anschaltung zwecks höherer Meßgenauigkeit. Eine richtige Vierdraht-Anschaltung wäre wünschenswert, läßt sich jedoch aus Platz- und Kostengründen nicht immer realisieren.

Vorgesehen ist des weiteren ein Guard-Verstärker VG, der eine Guard-Spannung UG und einen Guard-Strom IG erzeugt und mit dessen Hilfe einzelne Funktionsgruppen der integrierten Halbleiterschaltungen oder auch der Außenbeschaltung elektrisch abschalten lassen.

Des weiteren ist vorgesehen ein zweites Spannungsmeßgerät $MU_2$ und ein zweites Strommeßgerät $MI_2$, mit deren Hilfe sich Spannungs- und Strommessungen an anderen Teilen der Platine 1 durchführen lassen, wenn die Testgenauigkeit oder sonstige Gründe dies geboten erscheinen lassen.

Eine Einspeisung von Spannung und Strom erfolgt dabei jedoch nicht. Ein Kurzschlußkontakt erlaubt es, das Spannungsmeßgerät $MU_2$ während der Strommessung zu überbrücken.

Schließlich erkennt man einen Testcomputer C, der den Testablauf steuert und die Vergleichsberechnungen durchführt.

**Patentansprüche**

1. Verfahren zum Testen von Platinen (1), die mit integrierten Halbleiterschaltkreisen (IC, IC1, IC2) und sonstigen Bauelementen bestückt sind, auf Pinkontakt und Integrität der Funktionsgruppen unter Verwendung von Teststiften (S0,S1..Sx), die einen elektrischen Kontakt zu Testpunkten auf der Platine (1) herstellen, mit folgenden Verfahrensschritten:
   - im einer Lernphase werden einmalig und unter Verwendung einer fehlerfreien Platine (1) zwischen Paaren von Teststiften (S0-S1, S0-S2....) nacheinander die Impedanzen in Abhängigkeit von der Testdauer gemessen und als Vergleichswerte ZV in einem Speicher abgelegt, und anschließend nacheinander die Zuleitungen zu den Anschlußpins (P0, P1, P2, P3...) der integrierten Halbleiterschaltkreise (IC, IC1, IC2) bzw. der sonstigen Bauelemente aufgetrennt und dabei ebenfalls zwischen Paaren von Teststiften (S0-S1, S0-S2....) jeweils die Impedanzen zum Meßzeitpunkt gemessen und als Vergleichswerte Zv in einem Speicher abgelegt;
   - in der Testphase werden zwischen denselben Paaren von Teststiften (S0-S1, S0-S2,...) nacheinander die Istwerte Z-ist der Impedanzen zum Meßzeitpunkt gemessen und mit den gespeicherten Vergleichswerten Zv verglichen.

2. Verfahren nach Anspruch 1, dadurch gekennzeichnet, daß zusätzlich für jedes Paar vom Teststiften (S0-S1, S0-S2...) die Vergleichswerte und die Istwerte der Knickspannung (ux) bestimmt werden, indem die Testspannung (ut) so lange erhöht wird, bis ein sprunghaft steigender Teststrom (it) gemessen werden kann.

3. Verfahren nach Anspruch 1 oder 2, dadurch gekennzeichnet, daß in der Testphase nur die Paare von Teststiften (S0-S1, S0-S2...) ausgemessen werden, deren Vergleichswerte Ukv und Zv signifikante Unterschiede zwischen Gut und Schlecht besitzen.

4. Verfahren nach Anspruch 1,2 oder 3, dadurch gekennzeichnet, daß mit Hilfe eines weiteren Teststifts (S3) eine Guard-Spannung ug bzw. ein Guardstrom ig an bzw. in einen der integrierten Halbleiterschaltkreise (IC, IC1, IC2) angelegt bzw. eingespeist wird.

5. Verfahren nach einem der Ansprüche 1 bis 4, dadurch gekennzeichnet, daß zusätzlich die Vergleichswerte und die Istwerte von Spannung, Strom oder der Impedanz an einem weiteren Paar von Teststiften bestimmt werden.

6. Verfahren nach einem der Ansprüche 1 bis 5, dadurch gekennzeichnet, daß anstelle der Impedanz der differentielle Widerstand $Rv = (u1-U2)/(I1-I2)$ anhand zweier Spannungs- und Strommessungen bestimmt wird.

7. Vorrichtung zur Durchführung des Verfahrens nach einem der Ansprüche 1 bis 6, umfassend
   - ein Paar Teststifte (S0,S1...), die den elektrischen Kontakt zu der Platine (1) herstellen,
   - einen Testspannungsgenerator (GUt) mit steuerbarer Ausgangsspannung (ut),
   - ein Spannungsmeßgerät (NUt),
   - ein Teststrommeßgerät (MIt) und
   - eine Vorrichtung zum Errechnen der Impedanz.

8. Vorrichtung nach Anspruch 7, gekennzeichnet durch
   - eine Pseudo-Vierdraht-Anschaltung des Testspannungsmeßgerätes (MUt).

9. Vorrichtung nach Anspruch 7 oder 8, gekennzeichnet durch
   - einen Guardverstärker (VG).

10. Vorrichtung nach einem der Ansprüche 7 bis 9, gekennzeichnet durch
   - ein zweites Spannungsmeßgerät (MU2), ein zweites Strommeßgerät (MI2) oder ein entsprechendes Impedanzmeßgerät.

11. Vorrichtung nach einem der Ansprüche 7 bis 10, gekennzeichnet durch
   - einen Testadapter (TA),
     -- in der Lernphase einsetzbar zwischen Platine (1) und den zu prüfenden Bauelementen (IC, IC1, IC2...),
     -- enthaltend je einen Unterbrecherkontakt (Ux) in jeder Testadapterleitung.

12. Vorrichtung nach Anspruch 11, gekennzeichnet durch
   - Relais (Rlx) zur Betätigung der Unterbrecherkontakte (Ux).

13. Vorrichtung nach einem der Ansprüche 7 bis 11, gekennzeichnet durch
   - einem Testcomputer (C)
     -- zum Herstellen der Verbindungen des Testspannungsgenerators (Gut) und der Meßgeräte (MUt, MIt, MR, MU2, MI2, MR2) mit den richtigen Teststiften (S0, S1...)
       --- zur Aufnahme und Speicherung der Vergleichswerte Ukv, Ikv, Zv, Rv in der Lernphase und
       --- zur Aufnahme und Auswertung der Istwerte UKist, ZVist, RVist in der Testphase.

Vcc

Z1  Z3  Z7  Z9

Z5

P  1  P  2

Z6

Z2  Z4  Z8  Z10

GND

Fig. 1

$i_T$  I4

I3

I2
I1

UK1 U1 U2 UK2 U3 U4  $U_T$

Fig. 2

Fig. 3

Fig. 4

Fig. 5